Europäisches Patentamt

European Patent Office

Office européen des brevets

(19)

(11) Veröffentlichungsnummer: **0 348 805**
**A2**

# EUROPÄISCHE PATENTANMELDUNG

(21) Anmeldenummer: 89111260.9

(22) Anmeldetag: 21.06.89

(51) Int. Cl.⁴: **H03M 5/14**

(30) Priorität: 27.06.88 DE 3821450

(43) Veröffentlichungstag der Anmeldung:
03.01.90 Patentblatt 90/01

(84) Benannte Vertragsstaaten:
AT BE CH DE ES FR GB GR IT LI LU NL SE

(71) Anmelder: **DEUTSCHE THOMSON-BRANDT GMBH**

**D-7730 Villingen-Schwenningen(DE)**

(72) Erfinder: **Scholz, Werner, Dipl.-Ing.**
**Osterstrasse 20**
**D-3007 Gehrden(DE)**

(74) Vertreter: **Körner, Peter, Dipl.-Ing.**
**Deutsche Thomson-Brandt GmbH Patent-**
**und Lizenzabteilung Göttinger Chaussee 76**
**D-3000 Hannover 91(DE)**

(54) Übertragungssystem mit einem Übertragungscode für binäre Daten.

(57) Bei einem Übertragungssystem gemäß der DE-OS 36 05 396 ist für die Demodulation ein ROM vorgesehen, bei dem die Zahl der verfügbaren Speicherplätze größer ist als die Zahl der Codewörter. Die Aufgabe besteht darin, eine solche Schaltung besser auszunutzen.

Die nicht benutzten Speicherplätze des ROM werden alternativ zur Fehlererkennung mit einem vorgegebenen Wort belegt oder zur Fehlerkorrektur mit speziellen m-bit-Wörtern belegt.

Insbesondere für die Aufzeichnung von digitalen Ton-oder Videosignalen.

EP 0 348 805 A2

## Übertragungssystem mit einem Übertragungscode für binäre Daten

Die Erfindung geht aus von einem Übertragungssystem gemäß dem Oberbegriff des Anspruchs 1. Ein derartiges Übertragungssystem ist bekannt durch die DE-OS 36 05 396.

Bei dem Übertragungssystem gemäß dieser DE-OS wird in Fig. 2 die Demodulation des Signals mit der im ROM-Speicher 3 abgelegten Tabelle gemäß Tafel 1 oder Tafel 2 durchgeführt. Die Tafeln 1 und 2 vorliegender Anmeldung zeigen die Modulationstabelle. Daraus ergibt sich, daß von 1024 verfügbaren 10-bit-Wörtern nur 586 als Codewort verwendet werden. Das ROM für die Demodulation besitzt daher 438 ungenutzte Speicherplätze. Das bedeutet eine relativ schlechte Ausnutzung der Schaltung.

Der Erfindung liegt die Aufgabe zugrunde, bei der bekannten Demodulationsschaltung die Ausnutzung der Schaltung zu verbessern.

Diese Aufgabe wird durch die im Anspruch 1 angegebene Erfindung gelöst. Vorteilhafte Weiterbildungen der Erfindung sind in den Unteransprüchen angegeben.

Bei der Erfindung werden also die nicht benötigten Speicherplätze des ROM in vorteilhafter Weise zusätzlich entweder für eine Fehlererkennung oder eine Fehlerkorrektur des der Tabelle entnommenen m-bit-Wortes ausgenutzt. Für diese beiden Funktionen werden also keine zusätzlichen Bauteile benötigt. Sie erfordern keine zusätzliche Redundanz und unterstützen die vorhandenen Methoden zur Fehlererkennung und Fehlerkorrektur.

Für die Fehlererkennung gemäß der Alternative a) werden die nicht benutzten Speicherplätze mit einem vereinbarten Wert, z.B. "00000000" belegt. Wird dann aus dem ROM dieser Wert gelesen, so wird geprüft, ob das 10-bit-Eingangswort (m = 10) den Wert 155 oder 350 der Modulationstabelle hatte. Ist dies nicht der Fall, so kann daraus geschlossen werden, daß das Eingangswort fehlerhaft ist. Zur Erleichterung oder Vermeidung dieser Prüfung kann z.B. die m/n-Codetabelle so aufgestellt werden, daß dem vereinbarten m-bit-Wort (00000000) nur ein bzw. kein n-bit-Codewort zugeordnet ist.

Gemäß der Alternative b) kann auch eine Fehlerkorrektur von fehlerhaften Eingangswörtern erfolgen:

Von den nicht benutzten 10-bit-Wörtern können 374 durch Veränderung von nur einem Bit aus einem Codewort entstehen. Bei 54 müssen zwei bit verändert werden. Setzt man daher in die Demodulationstabelle in die nicht benutzten Speicherplätze 8-bit-Wörter, die zu Codewörtern gehören, die sich von der 10-bit-Adresse des jeweils nicht benutzten Speicherplatzes durch möglichst wenige bits unterscheiden, so besteht die Möglichkeit, daß trotz vorhandener Bitfehler das richtige 8-bit-Wort der Tabelle entnommen wird.

In vielen Fällen gibt es mehrere Möglichkeiten, durch Veränderung von nur einem oder zwei bits bei einem nichtverwendeten 10-bit-Wort ein 10-bit-Codewort zu erzeugen. Bei Kenntnis der Eigenschaften des Übertragungskanals, z.B. bestimmter Signalverzerrungen, kann vorausgesagt werden, aus welchen 10-bit-Codewort das nicht als Codewort benutzte 10-bit-Muster mit höchster Wahrscheinlichkeit entstanden ist. In dem betreffenden, nicht einem Codewort zugeordneten Speicherplatz wird das dem obigen Codewort zugeordnete 8-bit-Wort abgelegt. Dadurch kann die Korrekturwirkung weiter erhöht werden.

Fehlerkennung und Fehlerkorrektur sind auch gleichzeitig anwendbar, und zwar vorzugsweise dann, wenn nur bei einer begrenzten Anzahl von nicht benutzten n-bit-Adressen die Entstehung aus einem bestimmten Codewort wahrscheinlich ist. Die restlichen n-bit-Adressen können dann wirkungsvoller lediglich für die Fehlererkennung verwendet werden.

| WERT | TAB. 0 | TAB. 1 | TAB. 2 | WERT | TAB. 0 | TAB. 1 | TAB. 2 |
|---|---|---|---|---|---|---|---|
| 0 | 155 0 | 155 1 | 350 0 | 64 | 348 0 | 88 2 | 348 2 |
| 1 | 157 0 | 157 1 | 366 0 | 65 | 349 1 | 89 0 | 349 0 |
| 2 | 158 0 | 42 2 | 374 0 | 66 | 354 2 | 354 2 | 747 2 |
| 3 | 171 0 | 171 1 | 375 0 | 67 | 355 0 | 355 0 | 748 0 |
| 4 | 173 0 | 173 1 | 377 0 | 68 | 356 2 | 357 1 | 749 0 |
| 5 | 174 0 | 43 1 | 378 0 | 69 | 357 0 | 90 0 | 753 0 |
| 6 | 179 0 | 179 1 | 414 0 | 70 | 358 0 | 91 1 | 358 0 |
| 7 | 181 0 | 181 1 | 430 0 | 71 | 361 0 | 92 2 | 362 0 |
| 8 | 182 0 | 44 2 | 438 0 | 72 | 362 0 | 93 0 | 363 0 |
| 9 | 185 0 | 185 1 | 439 0 | 73 | 363 1 | 98 1 | 364 0 |
| 10 | 186 0 | 45 0 | 440 0 | 74 | 364 1 | 99 2 | 365 0 |
| 11 | 188 0 | 46 0 | 441 0 | 75 | 365 0 | 100 2 | 755 0 |
| 12 | 203 0 | 203 1 | 442 0 | 76 | 369 0 | 101 0 | 370 0 |
| 13 | 205 0 | 205 1 | 443 0 | 77 | 370 0 | 102 1 | 371 0 |
| 14 | 206 0 | 50 2 | 444 0 | 78 | 371 0 | 103 1 | 372 0 |
| 15 | 211 0 | 211 1 | 462 0 | 79 | 372 1 | 394 2 | 373 0 |
| 16 | 213 0 | 213 1 | 470 0 | 80 | 373 1 | 395 0 | 756 0 |
| 17 | 214 0 | 51 0 | 471 0 | 81 | 394 0 | 396 1 | 757 0 |
| 18 | 217 0 | 217 1 | 473 0 | 82 | 395 0 | 397 1 | 795 0 |
| 19 | 218 0 | 52 0 | 474 0 | 83 | 396 2 | 104 2 | 797 0 |
| 20 | 219 0 | 53 0 | 475 0 | 84 | 397 0 | 402 0 | 798 0 |
| 21 | 220 0 | 54 0 | 476 0 | 85 | 398 2 | 403 0 | 811 0 |
| 22 | 221 0 | 55 0 | 477 0 | 86 | 402 0 | 404 1 | 813 0 |
| 23 | 227 0 | 227 1 | 483 0 | 87 | 403 0 | 405 0 | 814 0 |
| 24 | 229 0 | 229 1 | 485 0 | 88 | 404 2 | 105 1 | 819 0 |
| 25 | 230 0 | 56 0 | 486 0 | 89 | 405 0 | 409 0 | 406 0 |
| 26 | 233 0 | 233 1 | 489 0 | 90 | 406 0 | 106 1 | 821 0 |
| 27 | 234 0 | 57 0 | 490 0 | 91 | 409 0 | 107 1 | 410 0 |
| 28 | 235 0 | 58 0 | 492 0 | 92 | 410 0 | 108 0 | 411 0 |
| 29 | 236 0 | 59 0 | 606 0 | 93 | 411 1 | 109 1 | 412 0 |
| 30 | 237 0 | 60 0 | 622 0 | 94 | 412 0 | 418 0 | 413 0 |
| 31 | 241 0 | 61 0 | 630 0 | 95 | 413 2 | 419 0 | 822 0 |
| 32 | 242 0 | 70 0 | 631 0 | 96 | 418 0 | 420 1 | 823 0 |
| 33 | 244 0 | 74 0 | 633 0 | 97 | 419 0 | 421 0 | 824 0 |
| 34 | 283 0 | 283 1 | 634 0 | 98 | 420 0 | 113 1 | 825 0 |
| 35 | 285 0 | 285 1 | 670 0 | 99 | 421 0 | 425 0 | 826 0 |
| 36 | 286 0 | 75 0 | 686 0 | 100 | 422 0 | 114 0 | 426 0 |
| 37 | 298 0 | 298 1 | 694 0 | 101 | 425 0 | 115 1 | 427 0 |
| 38 | 299 0 | 299 1 | 695 0 | 102 | 426 1 | 116 1 | 428 0 |
| 39 | 300 0 | 300 1 | 696 0 | 103 | 427 0 | 117 1 | 429 0 |
| 40 | 301 0 | 301 1 | 697 0 | 104 | 428 0 | 138 2 | 827 0 |
| 41 | 302 0 | 76 0 | 698 0 | 105 | 429 0 | 139 0 | 434 0 |
| 42 | 306 0 | 306 1 | 699 0 | 106 | 433 0 | 140 1 | 435 0 |
| 43 | 307 0 | 307 1 | 700 0 | 107 | 434 1 | 141 1 | 436 0 |
| 44 | 308 0 | 308 1 | 701 0 | 108 | 435 0 | 142 1 | 437 0 |
| 45 | 309 0 | 309 1 | 718 0 | 109 | 436 0 | 146 1 | 828 0 |
| 46 | 310 0 | 77 0 | 726 0 | 110 | 437 0 | 147 0 | 839 0 |
| 47 | 313 0 | 313 1 | 727 0 | 111 | 451 0 | 148 1 | 843 0 |
| 48 | 314 0 | 78 0 | 728 0 | 112 | 452 2 | 149 1 | 454 0 |
| 49 | 315 0 | 82 0 | 729 0 | 113 | 453 0 | 150 1 | 458 0 |
| 50 | 316 0 | 83 0 | 730 0 | 114 | 454 0 | 151 2 | 459 0 |
| 51 | 330 0 | 330 1 | 731 0 | 115 | 457 0 | 152 0 | 460 0 |
| 52 | 331 0 | 331 1 | 732 0 | 116 | 458 0 | 153 0 | 461 0 |
| 53 | 332 0 | 332 1 | 733 0 | 117 | 459 2 | 154 0 | 846 0 |
| 54 | 333 0 | 333 1 | 739 0 | 118 | 460 0 | 155 1 | 466 0 |
| 55 | 334 0 | 84 0 | 741 0 | 119 | 461 0 | 156 2 | 467 0 |
| 56 | 338 0 | 338 1 | 742 0 | 120 | 465 0 | 163 0 | 468 0 |
| 57 | 339 0 | 339 1 | 743 0 | 121 | 466 1 | 164 2 | 469 0 |
| 58 | 340 0 | 340 1 | 744 0 | 122 | 467 0 | 165 0 | 851 0 |
| 59 | 341 0 | 341 1 | 745 0 | 123 | 468 0 | 166 2 | 853 0 |
| 60 | 342 0 | 85 0 | 342 0 | 124 | 469 0 | 167 1 | 854 0 |
| 61 | 345 0 | 345 1 | 746 0 | 125 | 481 0 | 168 2 | |
| 62 | 346 0 | 86 0 | 346 0 | 126 | 482 0 | | |
| 63 | 347 0 | 87 1 | 347 1 | 127 | 484 0 | | |

Tabelle 1

| WERT | TAB. 0 | | TAB. 1 | | TAB. 2 | | WERT | TAB. 0 | | TAB. 1 | | TAB. 2 | |
|---|---|---|---|---|---|---|---|---|---|---|---|---|---|
| 128 | 539 | 0 | 169 | 0 | 855 | 1 | 192 | 676 | 2 | 676 | 0 | 936 | 2 |
| 129 | 541 | 0 | 170 | 0 | 856 | 2 | 193 | 677 | 0 | 677 | 1 | 937 | 0 |
| 130 | 542 | 0 | 172 | 0 | 857 | 0 | 194 | 678 | 0 | 277 | 0 | 678 | 2 |
| 131 | 554 | 2 | 554 | 0 | 858 | 1 | 195 | 681 | 0 | 681 | 1 | 938 | 0 |
| 132 | 555 | 0 | 555 | 1 | 859 | 1 | 196 | 682 | 0 | 278 | 0 | 682 | 2 |
| 133 | 556 | 2 | 556 | 0 | 860 | 0 | 197 | 683 | 1 | 279 | 1 | 683 | 0 |
| 134 | 557 | 0 | 557 | 1 | 861 | 1 | 198 | 684 | 0 | 280 | 2 | 684 | 2 |
| 135 | 558 | 2 | 177 | 0 | 867 | 0 | 199 | 685 | 1 | 281 | 0 | 685 | 0 |
| 136 | 562 | 0 | 562 | 0 | 869 | 0 | 200 | 689 | 0 | 282 | 0 | 939 | 2 |
| 137 | 563 | 0 | 563 | 1 | 870 | 0 | 201 | 690 | 0 | 284 | 0 | 690 | 0 |
| 138 | 564 | 2 | 564 | 0 | 871 | 1 | 202 | 691 | 1 | 290 | 2 | 691 | 2 |
| 139 | 565 | 0 | 565 | 1 | 872 | 2 | 203 | 692 | 0 | 291 | 2 | 692 | 0 |
| 140 | 566 | 0 | 178 | 0 | 873 | 0 | 204 | 693 | 1 | 292 | 0 | 693 | 2 |
| 141 | 569 | 0 | 569 | 1 | 874 | 0 | 205 | 707 | 0 | 293 | 0 | 940 | 0 |
| 142 | 570 | 0 | 180 | 0 | 875 | 1 | 206 | 708 | 2 | 294 | 0 | 941 | 2 |
| 143 | 571 | 1 | 194 | 2 | 876 | 0 | 207 | 709 | 0 | 295 | 2 | 945 | 0 |
| 144 | 572 | 0 | 195 | 0 | 877 | 1 | 208 | 710 | 0 | 296 | 0 | 710 | 2 |
| 145 | 586 | 2 | 586 | 0 | 881 | 0 | 209 | 713 | 0 | 297 | 0 | 946 | 0 |
| 146 | 587 | 0 | 587 | 1 | 882 | 0 | 210 | 714 | 0 | 305 | 0 | 714 | 2 |
| 147 | 588 | 2 | 588 | 0 | 883 | 1 | 211 | 715 | 1 | 322 | 2 | 715 | 0 |
| 148 | 589 | 0 | 589 | 1 | 884 | 0 | 212 | 716 | 0 | 323 | 0 | 716 | 2 |
| 149 | 590 | 0 | 196 | 2 | 885 | 1 | 213 | 717 | 1 | 324 | 2 | 717 | 0 |
| 150 | 594 | 2 | 594 | 0 | 906 | 2 | 214 | 721 | 0 | 325 | 0 | 947 | 1 |
| 151 | 595 | 0 | 595 | 1 | 907 | 0 | 215 | 722 | 0 | 326 | 0 | 722 | 2 |
| 152 | 596 | 2 | 596 | 0 | 908 | 2 | 216 | 723 | 1 | 327 | 2 | 723 | 0 |
| 153 | 597 | 0 | 597 | 1 | 909 | 0 | 217 | 724 | 0 | 328 | 0 | 724 | 2 |
| 154 | 598 | 0 | 197 | 0 | 598 | 2 | 218 | 725 | 1 | 329 | 0 | 725 | 0 |
| 155 | 601 | 0 | 601 | 1 | 910 | 0 | 219 | 737 | 0 | 337 | 0 | 948 | 2 |
| 156 | 602 | 0 | 198 | 0 | 602 | 2 | 220 | 738 | 0 | 353 | 0 | 738 | 0 |
| 157 | 603 | 1 | 199 | 1 | 603 | 2 | 221 | 740 | 0 | 389 | 0 | 740 | 2 |
| 158 | 604 | 0 | 200 | 2 | 604 | 2 | 222 | 779 | 0 | 390 | 0 | 949 | 1 |
| 159 | 605 | 1 | 201 | 0 | 605 | 0 | 223 | 781 | 0 | 392 | 2 | 953 | 2 |
| 160 | 610 | 2 | 610 | 0 | 914 | 2 | 224 | 782 | 0 | 393 | 0 | 962 | 0 |
| 161 | 611 | 0 | 611 | 1 | 915 | 0 | 225 | 786 | 2 | 401 | 0 | 963 | 2 |
| 162 | 612 | 2 | 612 | 0 | 916 | 2 | 226 | 787 | 0 | 417 | 0 | 964 | 0 |
| 163 | 613 | 0 | 613 | 1 | 917 | 0 | 227 | 788 | 2 | 531 | 0 | 965 | 2 |
| 164 | 614 | 0 | 202 | 0 | 614 | 2 | 228 | 789 | 0 | 533 | 0 | 966 | 0 |
| 165 | 617 | 0 | 617 | 1 | 918 | 0 | 229 | 790 | 0 | 534 | 0 | 790 | 2 |
| 166 | 618 | 0 | 204 | 0 | 618 | 2 | 230 | 793 | 0 | 537 | 0 | 967 | 1 |
| 167 | 619 | 1 | 209 | 0 | 619 | 2 | 231 | 794 | 0 | 538 | 0 | 794 | 2 |
| 168 | 620 | 0 | 210 | 0 | 620 | 2 | 232 | 796 | 0 | 540 | 0 | 796 | 2 |
| 169 | 621 | 1 | 212 | 0 | 621 | 0 | 233 | 802 | 2 | 546 | 2 | 968 | 2 |
| 170 | 625 | 0 | 225 | 0 | 919 | 2 | 234 | 803 | 0 | 547 | 0 | 969 | 0 |
| 171 | 626 | 0 | 226 | 0 | 626 | 2 | 235 | 804 | 2 | 548 | 2 | 970 | 0 |
| 172 | 627 | 1 | 223 | 0 | 627 | 0 | 236 | 805 | 0 | 549 | 0 | 971 | 1 |
| 173 | 628 | 0 | 266 | 2 | 628 | 2 | 237 | 806 | 0 | 550 | 0 | 806 | 2 |
| 174 | 629 | 1 | 267 | 0 | 629 | 2 | 238 | 809 | 0 | 552 | 2 | 810 | 0 |
| 175 | 650 | 2 | 650 | 1 | 920 | 0 | 239 | 810 | 0 | 553 | 0 | 810 | 2 |
| 176 | 651 | 0 | 651 | 0 | 921 | 2 | 240 | 812 | 0 | 561 | 0 | 812 | 0 |
| 177 | 652 | 2 | 652 | 1 | 922 | 0 | 241 | 817 | 0 | 579 | 2 | 973 | 1 |
| 178 | 653 | 0 | 653 | 0 | 923 | 1 | 242 | 818 | 0 | 580 | 0 | 818 | 0 |
| 179 | 654 | 2 | 268 | 2 | 924 | 0 | 243 | 820 | 0 | 581 | 0 | 977 | 2 |
| 180 | 658 | 0 | 658 | 1 | 925 | 2 | 244 | 835 | 0 | 582 | 0 | 978 | 0 |
| 181 | 659 | 0 | 659 | 1 | 930 | 0 | 245 | 837 | 0 | 583 | 1 | 979 | 2 |
| 182 | 660 | 2 | 660 | 0 | 931 | 2 | 246 | 838 | 0 | 584 | 0 | 842 | 0 |
| 183 | 661 | 0 | 661 | 1 | 932 | 0 | 247 | 841 | 0 | 585 | 0 | 980 | 2 |
| 184 | 662 | 0 | 269 | 0 | 933 | 2 | 248 | 842 | 0 | 593 | 2 | 850 | 0 |
| 185 | 665 | 0 | 665 | 1 | 666 | 2 | 249 | 844 | 0 | 609 | 0 | 852 | 2 |
| 186 | 666 | 0 | 270 | 0 | 667 | 0 | 250 | 849 | 0 | 645 | 0 | 980 | 0 |
| 187 | 667 | 1 | 274 | 2 | 668 | 2 | 251 | 850 | 0 | 646 | 2 | 850 | 2 |
| 188 | 668 | 0 | 275 | 0 | 669 | 0 | 252 | 852 | 0 | 648 | 0 | 852 | 1 |
| 189 | 669 | 1 | 276 | 2 | 934 | 0 | 253 | 865 | 0 | 649 | 0 | 981 | 2 |
| 190 | 674 | 2 | 674 | 0 | 935 | 0 | 254 | 866 | 0 | 657 | 0 | 866 | 2 |
| 191 | 675 | 0 | 675 | 1 | 935 | 1 | 255 | 868 | 0 | 673 | 0 | 868 | 2 |

Tabelle 2

**Ansprüche**

1. Übertragungssystem mit einem Übertragungscode für binäre Daten, der aus aufeinanderfolgenden n-bit-Wörtern besteht, wobei einem n-bit-Codewort ein m-bit-Datenwort zugeordnet, m kleiner als n ist, die Codierung und/oder Decodierung vorgegebenen Tabellen entspricht und die Demodulation entsprechend der Tabelle in einem ROM-Speicher erfolgt, bei dem die Zahl der verfügbaren Speicherplätze größer ist als die Zahl der Codewörter, **dadurch gekennzeichnet, daß**

a) Zur Fehlererkennung werden die nicht benutzten Speicherplätze mit einem vorgegebenen Wort ("00000000") belegt, und wenn dieses Wort aus dem ROM gelesen wird, erfolgt die Ausgabe eines Fehlersignals, gegebenenfalls wird vorher geprüft, ob das n-bit-Eingangswort einen Wert (155, 350) der Tabelle hatte.

und/oder

b) Zur Fehlerkorrektur werden die nicht benutzten Speicherplätze mit m-bit-Datenwörtern belegt die lt. Tabelle Codewörtern zugeordnet sind,die sich von der betr. n-bit-Speicheradresse in der Weise unterscheiden, daß die Wahrscheinlichkeit für das Entstehen dieser Adresse aus dem Code wort durch eine fehlerhafte Übertragung möglichst groß ist, so daß die Möglichkeit besteht, trotz fehlerhafter Übertragung des Codewortes dem ROM das richtige Datenwort zu entnehmen.

2. System nach Anspruch 16, **dadurch gekennzeichnet,** daß die nicht benutzten Speicherplätze des ROM mit m-bit-Wörtern belegt sind, die zu n-bit-Codewörtern gehören, die sich von der n-bit-Adresse des jeweils nicht benutzten Speicherplatzs durch möglichst wenige bits unterscheiden.

3. System nach Anspruch 1 oder 2, **dadurch gekennzeichnet,** daß der Code ein 8/10 Code ist (m = 8; n = 10).